## Europäisches Patentamt

## European Patent Office

## Office européen des brevets

(19)

(11) Veröffentlichungsnummer: **0 161 709**
**A2**

(12) **EUROPÄISCHE PATENTANMELDUNG**

(21) Anmeldenummer: **85200658.4**

(22) Anmeldetag: **29.04.85**

(51) Int. Cl.⁴: **H 03 K 3/023**

(30) Priorität: **12.05.84 DE 3417624**

(43) Veröffentlichungstag der Anmeldung: **21.11.85**
**Patentblatt 85/47**

(84) Benannte Vertragsstaaten: **CH DE FR GB IT LI SE**

(71) Anmelder: **Philips Patentverwaltung GmbH,**
**Billstrasse 80, D-2000 Hamburg 28 (DE)**

(84) Benannte Vertragsstaaten: **DE**

(71) Anmelder: **N.V. Philips' Gloeilampenfabrieken,**
**Groenewoudseweg 1, NL-5621 BA Eindhoven (NL)**

(84) Benannte Vertragsstaaten: **CH FR GB IT LI SE**

(72) Erfinder: **Schemmel, Hans-Robert, Dipl.-Ing.,**
**Friedrichstrasse 49/I, D-8500 Nürnberg (DE)**
Erfinder: **Schönamsgruber, Hermann, Münchauracher**
**Weg 20, D-8500 Nürnberg (DE)**

(74) Vertreter: **Peuckert, Hermann et al, Philips**
**Patentverwaltung GmbH**
**Billstrasse 80 Postfach 10 51 49,**
**D-2000 Hamburg 28 (DE)**

(54) **Schaltungsanordnung zur Umsetzung eines Wechselstromsignales in ein Binärsignal.**

(57) Die beschriebene Schaltungsanordnung setzt ein Wechselstromsignal in ein Binärsignal um, wenn der Pegel des Wechselstromsignales eine anfängliche Schwellspannung überschreitet. Während der Abgabe des Wechselstromsignales wird die Schwellspannung abgesenkt. Unterschreitet der Pegel des Wechselstromsignales die abgesenkte Schwellspannung, so wird die Abgabe des Wechselstromsignales unterbrochen und die Schwellspannung wieder auf ihren anfänglichen Wert angehoben. Diese Hysterese beim Ein- und Ausschalten des Binärsignales führt dazu, daß entweder ein fehlerfreies oder überhaupt kein Binärsignal abgegeben wird.

EP 0 161 709 A2

Philips Patentverwaltung GmbH          PHD 84 322 EP
N.V. Philips' Gloeilampenfabrieken      28.03.1985


Schaltungsanordnung zur Umsetzung eines Wechselstromsignales in ein Binärsignal


Die Erfindung betrifft eine Schaltungsanordnung zur Umsetzung eines Wechselstromsignales in ein Binärsignal, bei der das Wechselstromsignal dem invertierenden Eingang eines mitgekoppelten Komparators zugeführt wird, die Mitkopplung über einen ersten Spannungsteiler erfolgt, dessen Abgriff mit dem nicht invertierenden Eingang des Komparators verbunden ist, und beider einem Anschluß des ersten Spannungsteilers das Binärsignal zugeführt wird.

Eine Schaltungsanordnung mit den genannten Merkmalen wird z.B. benötigt, wenn bei Trägerfrequenzsystemen der Träger regeneriert oder derart aufbereitet werden soll, daß mit ihm digitale Bausteine angesteuert werden können.

Eine Anordnung der eingangs genannten Art ist in Tietze, U. und Schenk, Ch.: Halbleiterschaltungstechnik. 5. Auflage Springer-Verlag Berlin Heidelberg New York 1980, Seite 414 beschrieben. Bei der bekannten Anordnung handelt es sich um einen Schmitt-Trigger, der aus einem Operationsverstärker als Komparator aufgebaut ist und bei dem mit Hilfe eines Spannungsteilers ein Bruchteil der Ausgangsspannung an den nicht-invertierenden Ein-

-2-

gang gelegt ist. Das Wechselstromsignal liegt am invertierenden Eingang des Operationsverstärkers an. Überschreitet die Spannung am invertierenden Eingang eine positive Schwellspannung, springt die Ausgangsspannung des Operationsverstärkers auf ihren kleinsten Wert, unterschreitet sie eine negative Schwellspannung, springt die Ausgangsspannung auf ihren höchsten Wert. Liegen die Spannungswerte des Wechselstromsignales zwischen den beiden Schwellspannungen, ändert sich die Ausgangsspannung des Operationsverstärkers nicht.

Die bekannte Anordnung hat den Nachteil, daß die Flanken des Binärsignales am Ausgang des Operationsverstärkers gegenüber den Nullstellen des Wechselstromsignales zeitlich verschoben sind. Diese unerwünschte Phasenverschiebung ist vom Pegel und von der Kurvenform des Eingangssignals sowie von den Schwellspannungen abhängig. Schließlich liefert die bekannte Schaltung ein stark gestörtes Binärsignal, wenn die Scheitelwerte des Wechselstromsignales in der Nähe der Schwellspannungen liegen. Durch geringfügige Störungen im Wechselstromsignal kann dann nämlich der Fall eintreten, daß z.B. die positive Schwellspannung nur manchmal überschritten wird und dadurch die im Binärsignal auftretenden Wechsel der Binärwerte vom Zufall abhängen.

Der Erfindung liegt die Aufgabe zugrunde, eine Schaltungsanordnung der eingangs genannten Art anzugegeben, bei der die Flanken des Binärsignales möglichst gut mit den Nullstellen des Wechselstromsignales übereinstimmen und die trotz Störungen ein fehlerfreies Binärsignal mit der Frequenz

- 3 -

-3-

des Wechselstromsignales liefert, sobald das
Wechselstromsignal erstmalig eine Schwellspannung
überschritten hat.

Diese Aufgabe wird dadurch gelöst, daß der andere
Anschluß des ersten Spannungsteilers mit dem negativen Pol einer Gleichspannungsquelle verbunden
ist, deren positiver Pol auf Bezugspotential gelegt ist, daß der negative Pol der Gleichspannungsquelle über einen ersten Widerstand mit dem
invertierenden Eingang des Komparators verbunden
ist und daß der Abgriff des ersten Spannungsteilers über die Serienschaltung eines zweiten Widerstandes und eines Kondensators mit einem auf Bezugspotential liegenden Punkt verbunden ist.

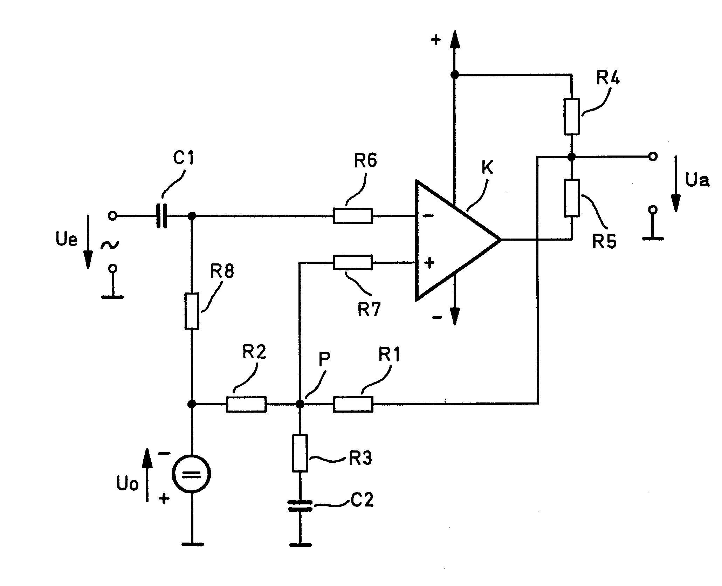

Anhand der Figur soll die Erfindung näher erläutert werden; die Figur zeigt ein Ausführungsbeispiel der Erfindung.

Ein Wechselstromsignal Ue wird über einen Koppelkondensator C1 und einen ersten Eingangswiderstand
R6 dem invertierenden Eingang eines Komparators K
zugeführt. Der nicht invertierende Eingang des
Komparators K ist über einen zweiten Eingangswiderstand R7 mit dem Abgriff P eines ersten Spannungsteilers R1, R2 verbunden. Außerdem führt eine
Serienschaltung eines Widerstandes R3 und eines
Kondensators C2 vom Abgriff P zu einem Punkt mit
Bezugspotential.

Der erste Spannungsteiler R1, R2 liegt zwischen
dem Abgriff eines zweiten Spannungsteilers R4, R5
und dem negativen Pol einer Gleichspannungsquelle
mit der Spannung Uo, deren positiver Pol auf Be-

- 4 -

-4-

zugspotential gelegt ist. Der negative Pol der Gleichspannungsquelle mit der Spannung Uo ist über einen Widerstand R8 auch mit dem invertierenden Eingang des Komparators K verbunden. Durch diese Verbindung liegt am invertierenden Eingang des Komparators K die Spannungs -Uo an, solange das Wechselstromsignal Ue nicht eingeschaltet ist.

Das Binärsignal Ua, in daß das Wechselstromsignal Ue umgesetzt werden soll, ist am Abgriff des zweiten Spannungsteilers R4, R5 abnehmbar. Der zweite Spannungsteiler R4, R5 liegt zwischen dem Ausgang des Komparators K und dem positivem Pol der Spannungsquelle, die den Komparator K versorgt. Durch den zweiten Spannungsteilers R4, R5 werden die beiden möglichen Spannungswerte Umax und Umin am Ausgang des Komparators K in nicht negative Spannungen UH und UL (H steht für "HIGH" und L steht für "LOW") des Binärsignales Ua umgesetzt, mit dem dann digitale Bausteine angesteuert werden können. Sind die Spannungen Umax und Umin schon für die Ansteuerung von digitalen Bausteinen geeignet, kann der zweite Spannungsteiler R4, R5 entfallen; ein Anschluß des ersten Spannungsteilers R1, R2 ist dann direkt mit dem Ausgang des Komparators K zu verbinden.

Da am nicht invertierenden Eingang des Komparators K - wegen seiner Verbindung mit dem Abgriff P des ersten Spannungsteilers R1, R2 - immer eine Spannung anliegt, die größer als -Uo ist, nimmt die Ausgangsspannung des Komparators K bei Abwesenheit des Wechselstromsignales Ue den Wert Umax an und am Abgriff des zweiten Spannungsteilers R4, R5 tritt dann die Spannung UH auf. Vor Einsetzen des

-5-

-5-

Wechselstromsignales Ue ist damit der Schaltzustand des Komparators K festgelegt; dieser Zustand werde Ruhezustand genannt. Am nicht invertierenden Eingang des Komparators K ist die Spannung im Ruhezustand um den Betrag $\dfrac{(Uo + UH)\, R2}{R1 + R2}$ größer als am invertierenden Eingang. Diese Ruheschwellspannung muß vom einsetzenden Wechselstromsignal Ue erst überschritten werden, bevor eine Änderung am Ausgang des Komparators K auftritt.

Nach dem ersten Zustandswechsel am Ausgang des Komparators K wird der Widerstand R3 und die Kapazität C2 wirksam. Diese Bauteile führen dazu, daß die Gleichspannungsdifferenz zwischen den Eingängen des Komparators K unter die Ruheschwellspannung abgesenkt wird und im Betriebszustand geringfügig um den Wert $\dfrac{UH\, R2}{R1 + R2}$, die Betriebsschwellspannung, schwankt. Bei jedem Über- oder Unterschreiten der Betriebsschwellspannung tritt ein Wechsel im Binärsignal Ua auf. Die Betriebsschwellspannung kann durch Wahl der Widerstände R1 und R2 so gelegt werden, daß die Flanken des Binärsignales Ua praktisch gleichzeitig mit den Nulldurchgängen des Wechselstromsignales Ue auftreten. Wegen der Absenkung der Schwellspannung ergibt sich immer ein fehlerfreies Binärsignal Ua, sobald zum ersten Mal das Wechselstromsignal Ue die hohe Ruheschwellspannung überschritten hat. Ist der Pegel des Wechselstromsignales Ue so klein geworden, daß erstmalig die Betriebsschwellspannung nicht überschritten werden kann, geht die Anordnung in ihren Ruhezustand über. Steigt der Pegel erneut an, so muß das Wechselstromsignal Ue

-6-

wieder die hohe Ruheschwellspannung überschreiten,
bevor die Anordnung ein Binärsignal Ua mit der
Frequenz des Wechselstromsignales Ue abgibt. Diese
Schalthysterese, die dazu führt, daß das
Binärsignal bei einem hohen Pegel des
Wechselstromsignales eingeschaltet und bei einem
niedrigen Pegel abgeschaltet wird, hängt von der
Spannung Uo der Gleichspannungsquelle ab und kann
mit ihr eingestellt werden.

Philips Patentverwaltung GmbH        PHD 84 322 EP
N.V. Philips' Gloeilampenfabrieken   28.03.1985

Patentansprüche

1. Schaltungsanordnung zur Umsetzung eines Wechselstromsignales (Ue) in ein Binärsignal (Ua), wobei

a) das Wechselstromsignal (Ue) dem invertierenden Eingang eines mitgekoppelten Komparators (K) zugeführt wird,

b) die Mitkopplung über einen ersten Spannungsteiler (R1, R2) erfolgt, dessen Abgriff (P) mit dem nicht invertierenden Eingang des Komparators (K) verbunden ist und einem Anschluß des ersten Spannungsteilers (R1, R2) das Binärsignal (Ua) zugeführt wird,

dadurch gekennzeichnet,

c) daß der andere Anschluß des ersten Spannungsteilers (R1, R2) mit dem negativen Pol einer Gleichspannungsquelle (Uo) verbunden ist, deren positiver Pol auf Bezugspotential gelegt ist,

d) daß der negative Pol der Gleichspannungsquelle (Uo) über einen ersten Widerstand (R8) mit dem invertierenden Eingang des Komparators (K) verbunden ist,

- 8 -

-8-

e) daß der Abgriff (P) des ersten Spannungsteilers (R1, R2) über die Serienschaltung eines zweiten Widerstandes (R3) und eines Kondensators (C2) mit einem auf Bezugspotential liegend Punkt verbunden ist.

2. Schaltungsanordnung nach Anspruch 1, dadurch gekennzeichnet, daß ein zweiter Spannungsteiler (R4, R5) vorgesehen ist, der zwischen dem Ausgang des Komparators (K) und dem positiven Pol der Spannungsquelle liegt, die den Komparator (K) versorgt, und daß der Abgriff des zweiten Spannungsteilers (R4, R5) mit einem Anschluß des ersten Spannungsteilers (R1, R2) verbunden ist.

0 161 709